# EUROPEAN PATENT APPLICATION

(11) **EP 1 522 890 A2**
(43) Date of publication of application: **13.04.2005**
(21) Application number: 04023762.0
(22) Date of filing: 06.10.2004
(51) Int. Cl.: G03F 7/00

(54) **Packaging method for lithographic printing plate**

(30) Priority: 06.10.2003 JP 2003347062
(71) Applicant: Fuji Photo Film Co., Ltd., Kanagawa (JP)
(72) Inventor: Usui, Takayuki Fuji Photo Film Co., Ltd., Haibara-gun Shizuoka (JP)
(74) Representative: HOFFMANN - EITLE

(57) **Abstract**

A layered bundle 12 is constructed by alternately superposing lithographic printing plates 10 and inserting paper sheets 14 in a thickness direction and further placing protective cardboards 22 on a top surface and a bottom surface of the superposed lithographic printing plates 10. The layered bundle 12 is packaged with packing paper 16. On this occasion, the layered bundle 12 is packaged so that an unsealing surface is placed on an opposite surface from an image forming surface 10P of the lithographic printing plate 10.

## Description

### BACKGROUND OF THE INVENTION

### Field of the Invention

The present invention relates to a packaging method for a lithographic printing plate, and particularly relates to a packaging method for a lithographic printing plate to package a lithographic printing plate with only one side surface formed as an image forming surface.

### Description of the Related Art

In a plate making method in recent years (including an electrophotographic plate making method), lithographic printing plates such as a photosensitive printing plate and a thermosensitive printing plate are widely used to facilitate automation of a plate making process. A lithographic printing plate is generally produced by performing surface treatments such as, for example, graining, anodic oxidation, silicate treatment, and other conversion treatments individually or suitably in combination for a substrate such as a sheet-shaped or coil-shaped aluminum plate, then by performing coating of a photosensitive layer or a thermosensitive layer (these are collectively called "coating film"), and drying treatment, and thereafter cutting the substrate into a desired size. This lithographic printing plate is subjected to plate making treatment such as exposure, developing treatment and gumming, is set at a printer, and coated with ink, and thereby letters, images or the like are printed on a paper sheet surface.

When this lithographic printing plate is handled as freight, a bundle of lithographic printing plates is sometimes constructed by layering a large quantity of lithographic printing plates in a thickness direction, and this bundle is housed in a packing box and packaged to reduce the number of freight handlings to perform transportation and storage at low cost.

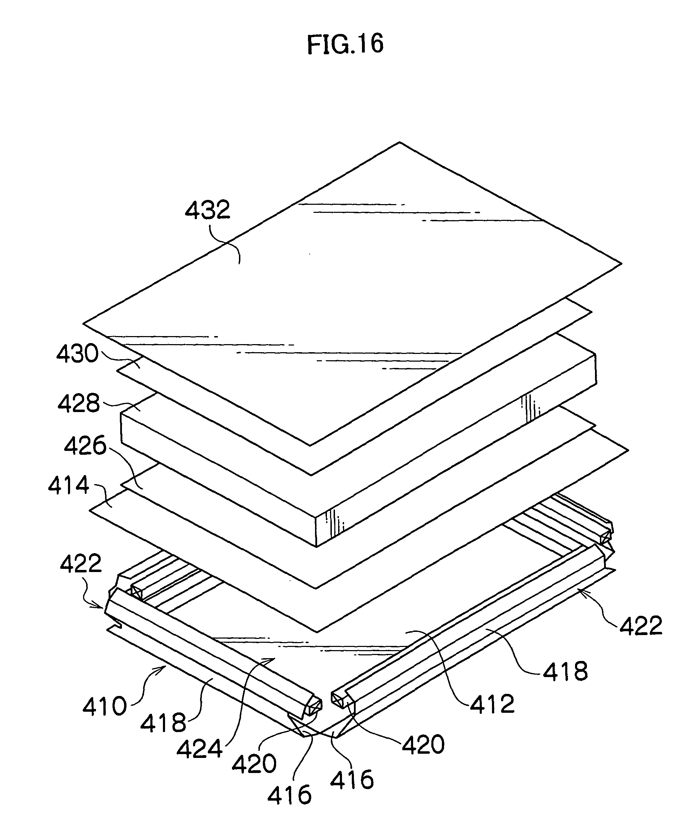

Fig. 16 shows an example of a lithographic printing plate packaging structure in which lithographic printing plates are housed in a packing box 410 and packaged (see Japanese Patent Application Publication No. 2000-95271).

In this packing box 410, after a bedding pad 414 is pasted on a bottom plate 412, side plates 416 and top plates 418 connectively provided from a peripherly of the bottom plate 412 are folded to wrap core materials 420, whereby frames 422 are constructed and a housing space 424 is constructed inside the frames 422. A bedding pad 426 is further pasted on the bedding pad 414, and a photosensitive material 428 is housed in the housing space 424. Thereafter, a lid back pad 430 of a lid plate 432 on which the lid back pad 430 is pasted is fitted inside the frames 422, and the lid plate 432 is fixed to a box body with an adhesive tape or the like.

Incidentally, depending on the apparatus in which this lithographic printing plate is used, the lithographic printing plate with only one side surface formed as an image forming surface is sometimes set at the apparatus with the image forming surface facing downward.

However, in the conventional lithographic printing plate packaging structure using the above-described packing box 410 or the like, a lithographic printing plate is generally accommodated so that an image forming surface is in the direction to oppose the lid plate 432 (upward in Fig. 16). Accordingly, a user needs to set the lithographic printing plate at the apparatus by inversing the lithographic printing plate after unpacking the packing box 410, which becomes a large operational burden.

The lithographic printing plate is generally formed to be a thin plate shape (for example, about 0.1 to 0.5 mm thick), and therefore the lithographic printing plate is sometimes deformed by receiving a local external force at the time of inverting operation. Even when the lithographic printing plate is not deformed, the coating film is sometimes peeled off the substrate by an external force.

In addition, in order to prevent deformation and peeling off of the film of the lithographic printing plate like this, the user has to perform the operations of loading the lithographic printing plate into the apparatus and inverting the lithographic printing plate by paying close attention, which further increases the operational burden.

Japanese Patent Application Publication No. 2001-194774 describes a packing case for packaging a pile constructed by superposing a plurality of photosensitive lithographic printing plates, which has an unsealing surface in each of the surface on the side of the photosensitive layer and the surface on the side of the substrate.

Japanese Patent Application Publication No. 2002-29173 describes that lithographic printing plates are accommodated in a packing box and packaged so that the image forming surfaces of the lithographic printing plates face an opposite side from an ejecting portion.

However, Japanese Patent Application Publication No. 2001-194774 and Japanese Patent Application Publication No. 2002-29173 have the problem that unpacking of the boxes are troublesome, and the boxes after unpacking are so bulky that it takes time and trouble to dispose of the boxes.

### SUMMARY OF THE INVENTION

The present invention is made in view of such circumstances, and has its object to provide a packaging method of lithographic printing plates which prevents deformation and peeling-off of films of the lithographic printing plates, is capable of setting the lithographic printing plates at an apparatus with a small operational burden, and further facilitates disposal of waste materials.

In order to attain the above-described object, a first aspect of the present invention is in a packaging method for a lithographic printing plate for packaging by a packing paper the lithographic printing plate with only one side surface formed as an image forming surface, comprising the step of: packaging the lithographic printing plate with the packing paper so that an unsealing surface of the packing paper is on an opposite side from the image forming surface.

When the packing paper is unpacked, unpacking is performed with the unsealing surface facing upward. Since the lithographic printing plate is accommodated so that the image forming surface faces an opposite side from the unsealing surface of the packing paper, and therefore when the lithographic printing plate is taken out of the unsealing surface, the lithographic printing plate is taken out with the image forming surface facing downward. Accordingly, when the lithographic printing plate is set at the apparatus with the image forming surface facing downward, it is not necessary to invert the lithographic printing plate, and the operational burden on the user is reduced. Deformation of the lithographic printing plate and peeling-off of the film following the inverting operation do not occur. Since packaging is performed with only the packing paper, the unpacking operation can be performed easily, and disposal of the waste materials can be performed easily.

A second aspect of the present invention is, in the first aspect of the invention, the image forming surface of the lithographic printing plate is constructed by a recording layer which changes in solubility for a developing solution by emission of laser light.

Generally, in the lithographic printing plate having an image forming surface constructed by such a recording layer, the coating film easily peels off and is damaged, but in the present invention, peeling-off of the film can be reliably prevented. In the lithographic printing plate having such a recording layer, it is possible to render an image directly on the image forming surface of the lithographic printing plate by emitting laser light.

According to the packaging method for the lithographic printing plate according to the present invention, since the lithographic printing plate is packaged so that the unsealing surface is on the opposite side from the image forming surface when the lithographic printing plate with only one side surface formed as the image forming surface is packaged with the packing paper, it is not necessary to invert the lithographic printing plate when the lithographic printing plate is set at the apparatus with the image forming surface facing downward, and therefore the operational burden on the user is reduced, thus eliminating deformation of the lithographic printing plate and occurrence of peeling-off of the film following the inverting operation. Packaging is only by the packing paper, and therefore the unpacking operation can be easily performed, thus making it possible to perform disposal of the waste materials easily.

### BRIEF DESCRIPTION OF THE DRAWINGS

Fig. 1 is a perspective view showing a process of packaging by using a packaging method according to the present invention;
Fig. 2 is a perspective view showing the process of packaging by using the packaging method according to the present invention;
Fig. 3 is a perspective view showing the process of packaging by using the packaging method according to the present invention;
Fig. 4 is a perspective view showing the process of packaging by using the packaging method according to the present invention;
Fig. 5 is an explanatory view showing a packaging method of a second embodiment;
Fig. 6 is a packaged body packaged in the second embodiment;
Fig. 7 is a perspective view showing a layered structure packaged in a third embodiment;
Fig. 8 is an explanatory view explaining a layered structure of a small pallet;
Fig. 9 is an explanatory view explaining the layered structure of the small pallet;
Fig. 10 is an explanatory view explaining a layered structure of a large pallet;
Fig. 11 is an explanatory view explaining the layered structure of the large pallet;
Fig. 12 is a packaged body packaged in a fourth embodiment;
Fig. 13 is a front view showing a schematic construction of an automatic plate maker in which packaged lithographic printing plates are used;
Fig. 14 is a side view showing a schematic construction of an inverting device;
Fig. 15 is a table showing the result of examples; and
Fig. 16 is a view showing an example of a conventional packaging structure in which the lithographic printing plates are housed in a packing box and packaged.

### DETAILED DESCRIPTION OF THE PREFERRED EMBODIMENTS

Embodiments of a packaging method for a lithographic printing plate according to the present invention will be explained hereinafter in accordance with the attached drawings.

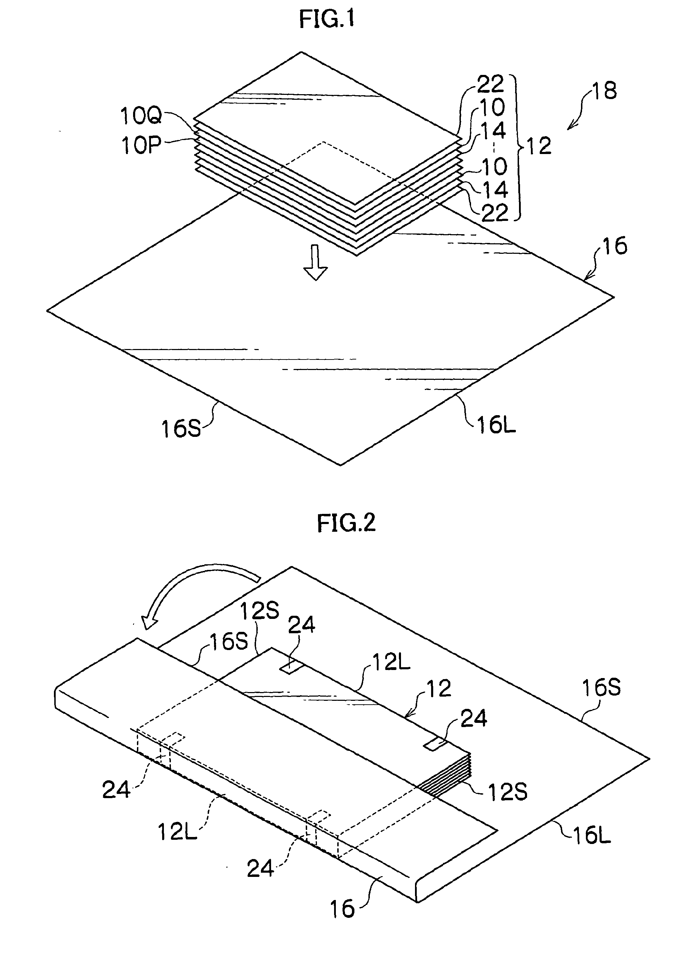

Fig. 1 to Fig. 4 show a process of packaging a lithographic printing plate 10 according to a packaging method of a first embodiment.

The lithographic printing plate 10 is formed by applying a coating film (a photosensitive layer in the case of a photosensitive printing plate, a thermosensitive layer in the case of a thermosensitive printing plate) onto a thin aluminum substrate formed into a rectangular plate shape. Plate making treatments such as exposure, developing treatment and gumming is performed for this coating film, the lithographic printing plate is set at a printing machine, and is coated with ink, whereby letters, images or the like are printed on a paper sheet surface. The lithographic printing plate 10 is that at the stage before treatments (exposure, development and the like) necessary for printing are performed, and it is called an original plate of the lithographic printing plate or a lithographic printing plate material in some cases. A surface on which this coating film is formed is called an image forming surface 10P, and a surface on which the coating film is not formed is called a non-image forming surface 10Q.

As shown in Fig. 1, the lithographic printing plates 10 are layered so that the image forming surfaces 10P become undersurfaces.

As long as this construction is adopted, a specific construction of the lithographic printing plate 10 is not especially limited, but, for example, the lithographic printing plates for laser printing plates of a heat mode type and a photon type are adopted, and thereby the lithographic printing plates capable of direct plate making from digital data can be provided.

The lithographic printing plate 10 can be a lithographic printing plate corresponding to various plate making methods by selecting various components in the photosensitive layer or thermosensitive layer. As examples of the specific mode of the lithographic printing plate of the present invention, the modes in the following (1) to (12) are cited.
(1) The mode in which the photosensitive layer contains a chemical compound that generates acid by an infrared ray absorbent and heat, and a chemical compound that bridges by acid.
(2) The mode in which the photosensitive layer contains a chemical compound that becomes soluble in alkali by an infrared ray absorbent and heat.
(3) The mode in which the photosensitive layer includes two layers that are a layer containing a chemical compound that generates a radical by laser light emission, a binder soluble in alkali, and poly functional monomer or prepolymer, and an oxygen blocking layer.
(4) The mode in which the photosensitive layer is constituted of two layers that are a physical development nuclear layer and a silver halide emulsion layer.
(5) The mode in which the photosensitive layer includes three layers that are a polymerization layer containing a polyfunctional monomer and a polyfunctional binder, a layer containing silver halide and a reducer, and an oxygen blocking layer.
(6) The mode in which the photosensitive layer includes two layers that are a layer containing a novolac resin and naphthoquinone di azide, and a layer containing silver halide.
(7) The mode in which the photosensitive layer includes an organic photo conductor.
(8) The mode in which the photosensitive layer includes two to three layers constituted of a laser light absorbing layer that is removed by laser light emission, a lipophilic layer and/or a hydrophilic layer.
(9) The mode in which the photosensitive layer includes a chemical compound that absorbs energy and generates oxygen, a high polymer compound having a functional group that generates sulfonic acid or carboxylic acid by acid in a side chain, and a chemical compound that gives energy to an acid generator by absorbing visible light.
(10) The mode in which the photosensitive layer contains a quinone di azide compound and a novolac resin.
(11) The mode in which the photosensitive layer contains a chemical compound that is decomposed by light or ultraviolet rays and forms a bridging structure with other molecules in itself or in the layer, and a binder soluble in alkali.
(12) The mode in which the photosensitive layer contains an infrared ray absorbent, a chemical compound that generates a radical by heat and a chemical compound bridges by the radical.

Especially, in recent years, a lithographic printing plate coated with a highly sensitive photosensitive type coating film which is exposed by laser, and a thermosensitive type lithographic printing plate are sometimes used (for example, the above-described modes (1) to (3) or the like), and in the case of such a highly sensitive type lithographic printing plate, degradation of quality of an image forming surface can be reliably prevented by packaging the lithographic printing plate by the packaging method of the lithographic printing plate according to the present invention.

The wavelength of the laser light mentioned here is not especially limited, and for example, the followings are cited as examples: (A) laser with a wavelength band of 350 to 450 nm (as a concrete example, laser diode with wavelengths of 405±5 nm), (B) laser with a wavelength band of 480 to 540 nm (as concrete examples, argon laser with a wavelength of 488 nm, (FD) YAG laser with a wavelength of 532 nm, solid laser with a wavelength of 532 nm, (green) He-Ne laser with a wavelength of 532 nm), (C) laser with a wavelength band of 630 to 680 nm (as concrete examples, He-Ne laser with wavelengths of 630 to 670 nm, red semiconductor laser with wavelengths of 630 to 670 nm), (D) laser with a wavelength band of 800 to 830 nm (as a concrete example, an infrared (semiconductor) laser with a wavelength of 830 nm), and (E) laser with wavelengths of 1064 to 1080 nm (as a concrete example, YAG laser with a wavelength of 1064 nm). Among them, for example, the laser lights with the wavelength bands of (B) and (C) are both applicable to both the lithographic printing plates having the photosensitive layer and the thermosensitive layer of the above-described modes (3) and (4). The laser lights with the wavelength bands of (D) and (E) are both applicable to both the lithographic printing plates having the photosensitive layer and the thermosensitive layer of the above-described modes (1) and (2). However, the relationship between the wavelength band of the laser light and the photosensitive layer or the thermosensitive layer is not limited to them.

The lithographic printing plates 10 of this embodiment (the lithographic printing plates of all the above-described modes (1) to (12)) are set at an automatic plate maker having an automatic plate feeding function, a so-called plate setter or the like in the state in which the lithographic printing plates 10 construct a layered bundle 12, and are supplied (plate feeding) to a plate making process in some cases.

As shown in Fig. 1, inserting paper sheets 14 for protecting the coating films and the lithographic printing plates 10 are alternately superposed on each other and protective cardboards 22 are placed on a top surface and an undersurface of them, whereby the layered bundle 12 of the lithographic printing plates 10 is constructed. The inserting paper sheet 14 is normally placed on the side in contact with the image forming surface 10P.

The number of lithographic printing plates 10 constructing one layered bundle 12 is not especially limited, but from the viewpoint of efficiency of transportation and storage, for example, 10 to 200 can be adopted. Namely, ten or more lithographic printing plates 10 are used, and thereby efficiency of freight handling can be enhanced. Limiting the number of printing plates 10 to 200 or less limits the weight of the layered bundle 12 itself, and therefore the operational burden in freight handling can be reduced. When the layered bundle 12 is constructed by the 10 to 200 of lithographic printing plates 10, it is preferable to fix them by a fixing device such as an adhesive tape so that the lithographic printing plates 10 and the protective cardboards 22 are not deviated from each other. It is also possible to construct the layered bundle 12 by a larger number of lithographic printing plates 10 to enable transportation and storage more efficiently (with smaller freight handling times). For example, the number of lithographic printing plates 10 is made about 6500 at the maximum, and the protective cardboard 22 may be inserted in every 20 to 100 of lithographic printing plates 10. The number of lithographic printing plates 10 is made about 3000 at the maximum, and the protective cardboards 22 may be placed only a top and a bottom of them. In addition, depending on the kind of the lithographic printing plate 10, the protective cardboard 22 may be omitted.

The aforementioned inserting paper sheet 14 is not limited in its concrete construction as long as it can reliably protect the coating film (image forming surface) of the lithographic printing plate 10, and for example, paper with use of 100% of wood pulp, paper with use of synthetic pulp instead of using 100% of wood pulp, paper provided with a low-density polyethylene layer on a surface of these paper sheets and the like can be used. Especially, the paper which does not use synthetic pulp becomes low in material cost, and therefore the inserting paper sheet 14 can be produced at low cost. More specifically, the inserting paper sheet made from bleached or partially bleached craft pulp, with a basic weight of 20 to 55 g/m², a density of 0.7 to 0.85 g/cm³, moisture of 4 to 8 % , Bekk smoothness of 10 to 800 seconds, and PH of 4 to 6 is cited, but the inserting paper sheet is not limited to this.

As the protective cardboard 22, the concrete construction is not limited as long as the protective cardboard 22 can reliably protect the lithographic printing plates, and for example, the protective cardboard 22 made from used paper with a basic weight of 200 to 1500 g/m², a density of 0.7 to 0.85 g/cm³, moisture of 4 to 8%, Bekk smoothness of 3 to 20 seconds, and PH of 4 to 6 can be cited. Depending on the kind of the lithographic printing plate 10, the protective cardboard 22 and the inserting paper sheet 14 may be omitted. In this case, if the packing paper 16 with the Bekk smoothness of at least a portion of the packing paper 16, which is in contact with the image forming surface of the lithographic printing plate 10, namely, the contact portion with the Bekk smoothness satisfying the above-described condition is used, the film is prevented from peeling off when the packing paper 16 robs the coating film due to transportation or the like, for example. Especially, when the packing paper 16 with the Bekk smoothness of the contact portion of 3 seconds to 100 seconds inclusive, or of 250 seconds to 900 seconds inclusive is used, the film of the lithographic printing plate 10 is prevented from peeling off irrespective of the kind of the lithographic printing plate 10.

The process of constructing the layered bundle 12 by layering the lithographic printing plates 10 in the thickness direction is not especially limited, but, for example, it is general to provide an accumulation device for sequentially accumulating the lithographic printing plates 10 in the work line of the lithographic printing plates which cuts the web-shaped lithographic printing plate in a predetermined size while conveying the lithographic printing plate in the longitudinal direction, and therefore the layered bundle 12 is constructed by accumulating the lithographic printing plates 10 in this accumulating device. In this work line, the likewise web-shaped inserting paper sheet is placed in contact with the web-shaped lithographic printing plate before cutting, and thereafter, the web-shaped lithographic printing plate and inserting paper sheet are integrally cut to be in a predetermined size in many cases. Therefore, in this case, in the state in which the lithographic printing plate 10 and the inserting paper sheet 14 are alternately layered on each other at the time of accumulation in the accumulating device, the layered bundle 12 is constructed. Of course, after the lithographic printing plate 10 and the inserting paper sheet 14 are alternately layered on each other, and thereafter the end portions of the lithographic printing plates 10 may be trimmed by a cutter or the like to construct the layered bundle 12.

The layered bundle 12 thus constructed is packaged with the packing paper 16 as shown in Fig. 2. The packing paper 16 is constructed by paper having light blocking effect and dampproof, and the layered bundle 12 is packaged to be blocked from an outside by using this packing paper 16, whereby the layered bundle 12 can be reliably blocked from light and protected from moisture.

The material of the packing paper 16 is not especially limited as long as it is possible to package the lalyered bundle 12 by blocking the layered bundle 12 from an outside, and the packing paper 16 can be constructed by for example, a piece of rectangular unbleached craft paper formed into a predetermined size. The paper constructed by pasting a thin metal film of a predetermined thickness on this craft paper and depending on the case, by further pasting a resin layer of a predetermined thickness on this thin metal film may be used. The paper constructed by further pasting a low density polyethylene layer of 10 to 70 µm on this thin metal film, and by pasting a black polyethylene film of about 70 µm on this low density polyethylene layer to be enhanced in light blocking effect and dampproof may be used. Generally, the photosensitive printing plate is high in photosensitivity, and even when it is exposed by light in a small visible light wavelength band, a change occurs to the photosensitive layer, thus making it necessary to block light. It is also preferable to suitably block light from the thermosensitive printing plate, because the thermosensitive layer sometimes degenerates by thermal energy of the light emitted thereon, and change in sensitivity occurs due to the progress in reaction. Further, when both the printing plates are subject to abrupt change in humidity and change in temperature, there arise the problems that both the printing plates degenerate as a result of condensation forms in the photosensitive layer and the thermosensitive layer, that they adhere to the inserting paper sheets 14, and the like, and therefore there arises the need for preventing moisture. Since the packing paper 16 has a constant light blocking effect and dampproof as a result of being constructed as above, the packing paper 16 prevents from degenerating the photosensitive layer or the thermosensitive layer of the lithographic printing plate 10, and keeps the lithographic printing plate 10 in a constant quality. It is natural that if only the packing paper 16 can exhibit the above-described constant light blocking effect and dampproof, it is not always necessary to paste the low density polyethylene layer, a black polyethylene film and the like on the packing paper 16. The packing paper 16 produced by the unbleached craft paper may be used, and in this case, it can be recycled as used paper. Namely, it is preferable because disposal such as reclamation and burning is not required, and the packing paper 16 can be easily cast away.

The shape, the interior structure (folding method of the interior paper) and the like of the packing paper 16 are not especially limited as long as the packing paper is capable of preventing moisture and blocking light from the layered bundle 12, and the layered bundle 12 is packaged by the packing paper 16 as shown in, for example, Fig. 2 to Fig. 4.

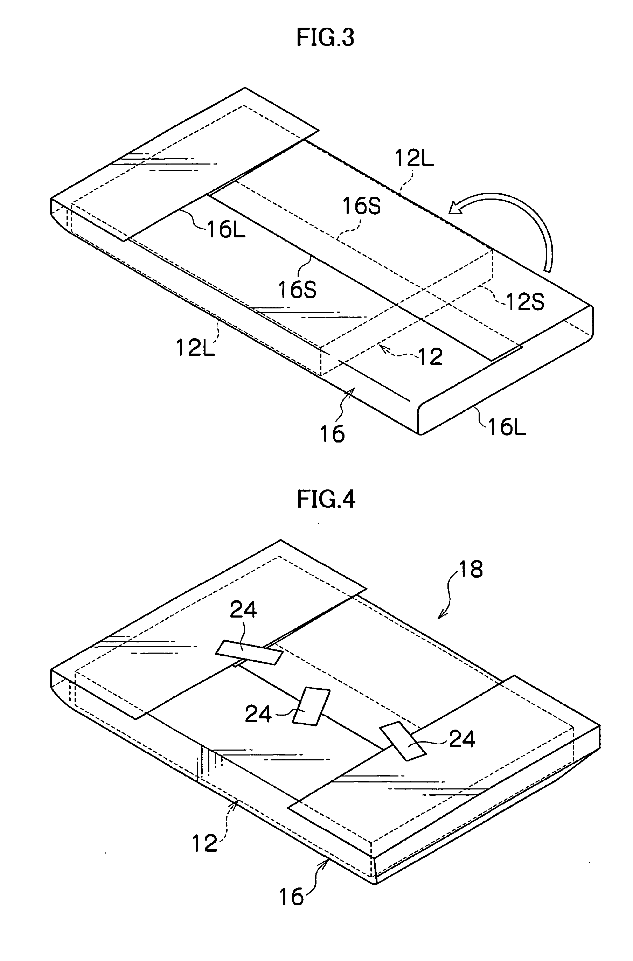

The length of a long side 16L of the packing paper 16 is set as a predetermined length so that the vicinities of short sides 16S of the packing paper 16 partially overlap one another (see Fig. 3) in the state in which the layered bundle 12 is placed at an approximately center of the packing paper 16 so that a long side 12L of the layered bundle 12 and the short side 16S of the packing paper 16 are parallel with each other, and the packing paper 16 is folded from both sides along the long side 12L of the layered bundle 12, as shown in Fig. 2.

The length of the short side 16S of the packing paper 16 is set as a predetermined length so that when the side of the long side 16L of the packing paper 16 is further folded from the state in which the vicinities of the short sides 16S partially overlap one another, the packing paper 16 partially overlaps a top surface of the layered bundle 12 in the plan view (see Fig. 3).

The layered bundle 12 is thus packaged with the packing paper 16, and thereby the entire surface of the layered bundle 12 is covered with the packing paper 16 as shown in Fig. 4. Finally, the packing paper 16 is stuck at predetermined positions with the adhesive tape 24 to fix the packing paper 16 so as not to be unfolded or fall off unexpectedly. Thereby, the packaged body with the unsealing surface placed on the top surface is formed.

In the packaging body of the lithographic printing plate 10 constructed as described above, the inserting paper sheet 14 is disposed in contact with the coating film, and therefore damage to the coating film such as so-called peeling off of the film is prevented. The layered bundle 12 is completely covered with the packing paper 16 having light blocking effect and dampproof, and blocked from the outside, and therefore the lithographic printing plates 10 constructing the layered bundle 12 are reliably blocked from light and moisture.

When the packaged lithographic printing plate 10 is used in this embodiment, the adhesive tape 24 is peeled off first, and the packing paper 16 is unsealed. Then, the lithographic printing plates 10 as in the layered bundle 12 (depending on the case, the lithographic printing plates 10 are manually set one by one) are set in the apparatus in use such as an automatic plate maker having an automatic plate feeding function and a so-called plate setter. At this time, in this embodiment, as described above, when a lithographic printing plate packing box 170 is unpacked with the unsealing surface up, the lithographic printing plate 10 can be taken up with the image forming surface 10P facing downward, and therefore the user of the lithographic printing plate 10 can directly set the lithographic printing plate 10 from the state in which the lithographic printing plate 10 is taken out without inverting the planograpihc printing plate 10, thus reducing the operational burden. It does not happen that the lithographic printing plate 10 is deformed by receiving a local external force by the inverting operation, or the coating film is peeled off, and the lithographic printing plate 10 is kept at a constant quality. Further, the lithographic printing plate 10 is packaged with only the packing paper 16, and therefore the used packing box does not generate as at the time when it is packaged by the packing box. Accordingly, the bulky used packing boxes are not generated, and it is not necessary to dispose of the packing boxes, thus requiring no cost and labor to dispose of the used packing boxes.

As another unsealing method of the packaged body, it is suitable to unseal the top surface with a sharp edged blade such as a cutter. In this case, the protective cardboard 22 is placed on the lithographic printing plate 10, and therefore the damage to the lithographic printing plate 10 can be prevented.

A cut in a perforated form or the like may be formed on the unsealed surface of the packaged body.

Next, a second embodiment of the packaging method according to the present invention will be explained.

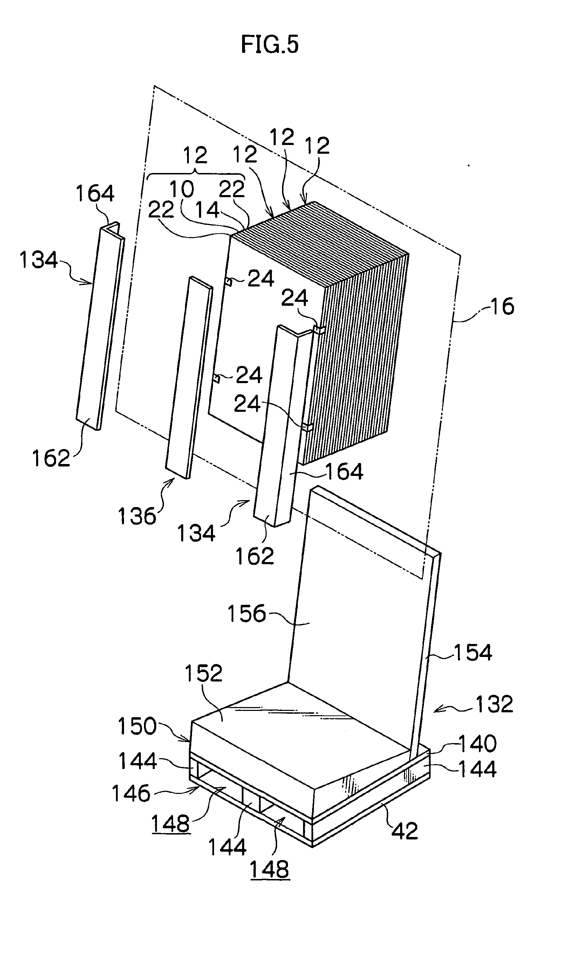

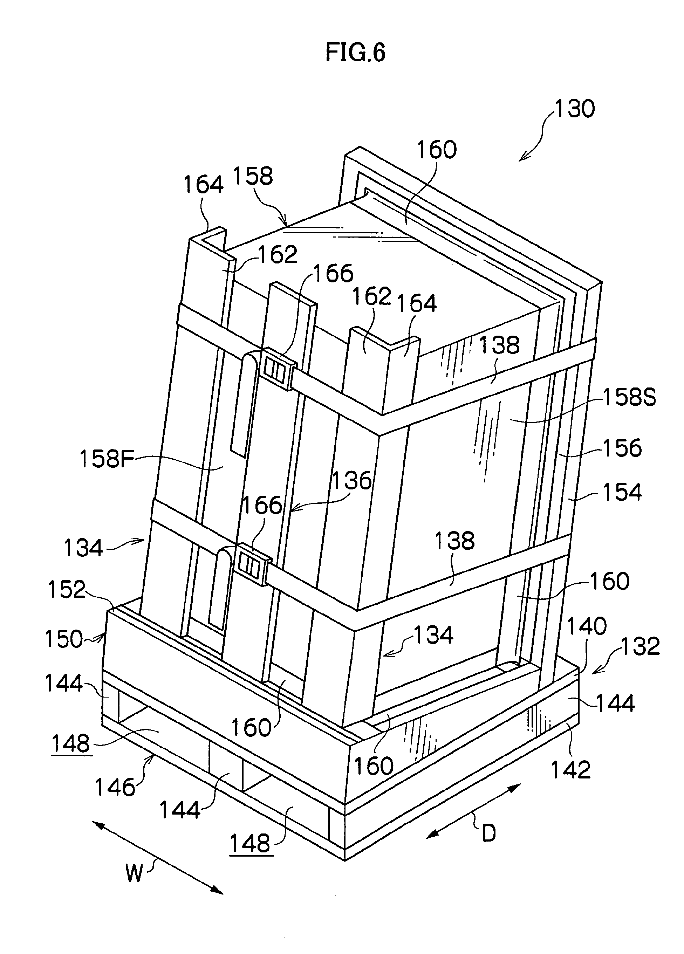

Fig. 5 is an explanatory view showing a packaging method of the second embodiment, and Fig. 6 shows a packaged body after being packaged.

A packaged body 130 is constructed by a loading member 132 (a so-called pallet or skid) on which the layered bundle 12 is loaded, comer cover plates 134 and a surface cover plate 136, which are applied to the layered bundle 12 loaded on this loading member 132 (more strictly, a packaged layered bundle 158 in Fig. 16), and fixing belts 138 (see Fig. 6) for fastening the comer cover plates 134 and the surface cover plate 136 against the loading member 132 from outside and fixing them.

The loading member 132 has a table portion 146 constructed by connecting an approximately rectangular upper plate 140 and a lower plate 142 by a plurality of leg portions 144 in a long shape or a block shape. Insertion portions 148 are defined between the leg portions 144, and the loading member 132 can be lifted up by inserting forks of a folk lift and a hand lift into this insertion portion 148. In Fig. 5 and Fig. 6, the leg portion 144, which is formed into a long shape along a depth direction (arrow D direction) of the table portion 146, and the insertion portion 148, which is constructed along the depth direction of the table portion 146, are cited, but, for example, the respective leg portions 144 may be formed into a shape divided into the depth direction (block shape), and the insertion portion 148 may be constructed not only in the depth direction but also in the width direction (the arrow W direction), so that the fork can be inserted from any direction.

A loading table 150 with an approximately wedge-shaped end surface is fixed on a top surface of the upper plate 140 of the table portion 146. The top surface of this loading table 150 is inclined with respect to the upper plate 140, and becomes a loading surface 152 on which the layered bundle 12 is loaded.

A planar support plate 154 is vertically provided from a lower end portion of the loading surface 152. A surface of the support plate 154 at the side of the loading surface 152 is perpendicular to the loading surface 152, and becomes a support surface 156 for supporting a part of the load of the layered bundle 12 when the layered bundle 12 is loaded on the loading surface 152. Subsequently, the layered bundle 12 is packaged with the packing paper 16 in the state in which the layered bundle 12 is loaded on the loading surface 152. Hereinafter, the packaged layered bundle 12 is called a packaged layered bundle 158. In Fig. 5, only one layered bundle 12 is shown, but a plurality of layered bundles 12 may be continuously loaded.

In the second embodiment, an insertion paper sheet 44 which has different thickness from the inserting paper sheet 14 is inserted in every predetermined number of lithographic printing plates 10 constructing the layered bundle 12. The insertion paper sheet 44 functions as a labeling member of the present invention, and when the layered bundle 12 is seen from sideways, the insertion paper sheets 44 are visually recognized as different from the lithographic printing plates 10 and the layered bundle 12. Therefore, at the time of using the lithographic printing plate 10, or the like, the lithographic printing plates 10 can be taken out in every predetermined number with the insertion paper sheet 44 as a mark. The labeling member of the present invention is not limited to the above-described insertion paper sheet 44, but anything may be used if only it is recognizable as different from the lithographic printing plates 10 and the inserting paper sheet 14 when the layered bundle 12 is seen sideways in short. For example, the paper sheet, which is made by coloring the paper sheet with the same construction as the inserting paper sheet 14 to the extent that does not influence the quality and handling of the lithographic printing plate 10 or by forming the paper sheet into the shape slightly bulging out of the layered bundle 12 so as to be visually recognizable for the operator, may be used.

In this embodiment, the packing paper 16 made by pasting an aluminum foil (thin metal film) of 6 to 7 µm on craft paper having a sufficient size for integrally packaging one or a plurality of layered bundles 12 loaded on the loading surface 152 is used as the packing paper 16. When a plurality of layered bundles 12 are loaded, each layered bundle 12 may be packaged with the packing paper 16.

A plurality of layered bundles 12 are integrally packaged with such packing paper 16. On this occasion, the layered bundles 12 are packaged so that the image forming surfaces 10P (see Fig. 1) are placed on the opposite sides from the unsealing surfaces as in the aforementioned first embodiment. Then, the end portion of the packing paper 16 is adhered to the loading table 150 and the support plate 154 by the adhering device such as an adhesive tape 160 or the like, and thereby the packaged layered bundle 158 is constructed.

The comer covering plate 134 is approximately L-shaped in an end surface, having a wide broad portion 162 and a narrow portion 164, and is formed into a long shape as a whole. The broad portion 162 is in surface contact with a front surface 158F of the packaged layered bundle 158 loaded on the loading surface 152, and the narrow portion 164 is in surface contact with a side surface 158S. The length of the comer covering plate 134 is set to be about the same as the height of the packaged layered bundle 158, or longer than this.

The surface covering plate 136 is formed to be approximately the same as the broad portion 162 of the comer covering plate 134 or to be a long shape thicker than the broad portion 162, and the surface covering plate 136 is applied to an approximately center in a width direction of the front surface 158F of the packaged layered bundle 158.

The fixing belt 138 has a sufficient length to be wound around the packaged layered bundle 158, the comer covering plates 134, the surface covering plate 136 and the support plate 154 in the state the comer covering plates 134 and the surface covering plate 136 are applied to the packaged layered bundle 158. When a buckle 166 is manipulated in the state in which the fixing belt 138 is wound around, the fixing belt 138 is gradually fastened, an inward force works on the packaged layered bundle 158, the comer covering plates 134, the surface covering plate 136 and the support plate 154, so that the packaged layered bundle 158, the comer covering plate 134 and the surface covering plate 136 can be easily fixed to the support plate 154. In this embodiment, as an example of the fixing belt 138, a lashing belt having a predetermined strength is used.

In the second embodiment thus constructed, packaging is performed so that the unsealing surface of the packing paper 16 is on the opposite side from the image forming surface 10P, and therefore the operation of taking out the lithographic printing plate 10 and setting it at an apparatus in use such as an automatic plate maker having an automatic plate feeding function and a so-called plate setter can be easily performed. Packaging is performed with only the packing paper 16 without using packing boxes, and therefore it does not happen that the packing boxes become bulky or that time and trouble are taken for disposal of the packing boxes, thus making it possible to reduce cost and efforts required for disposal of the packing boxes.

Next, a third embodiment of the packaging method according to the present invention will be explained.

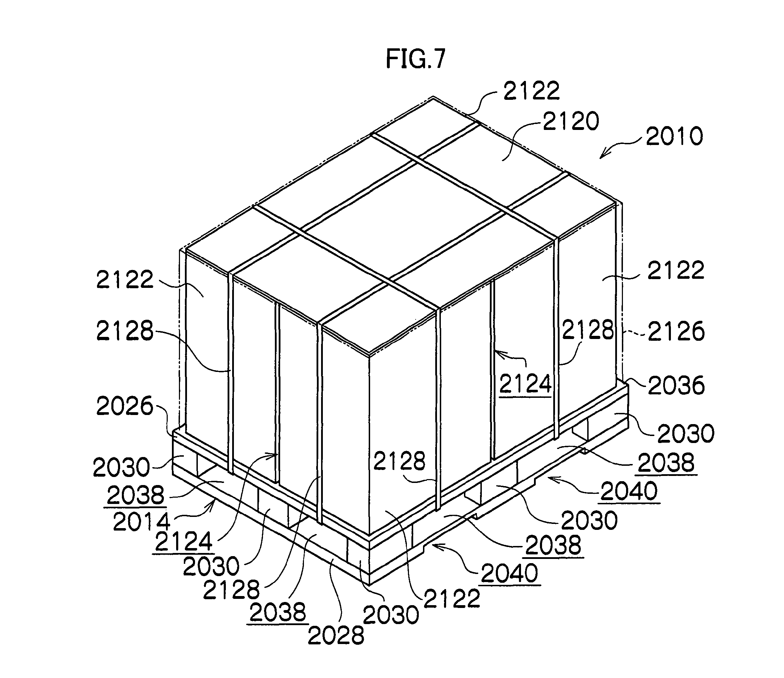

Fig. 7 to Fig. 11 show a loading structure of the lithographic printing plates 10, using two kinds of pallets (a small pallet and a large pallet) with different sizes.

As shown in Fig. 7, a loading structure 2010 includes small pallets 2012 on which the layered bundle 12 of the lithographic printing plates 10 is loaded, and a large pallet 2014 on which a plurality of small pallets 2012 are further loaded.

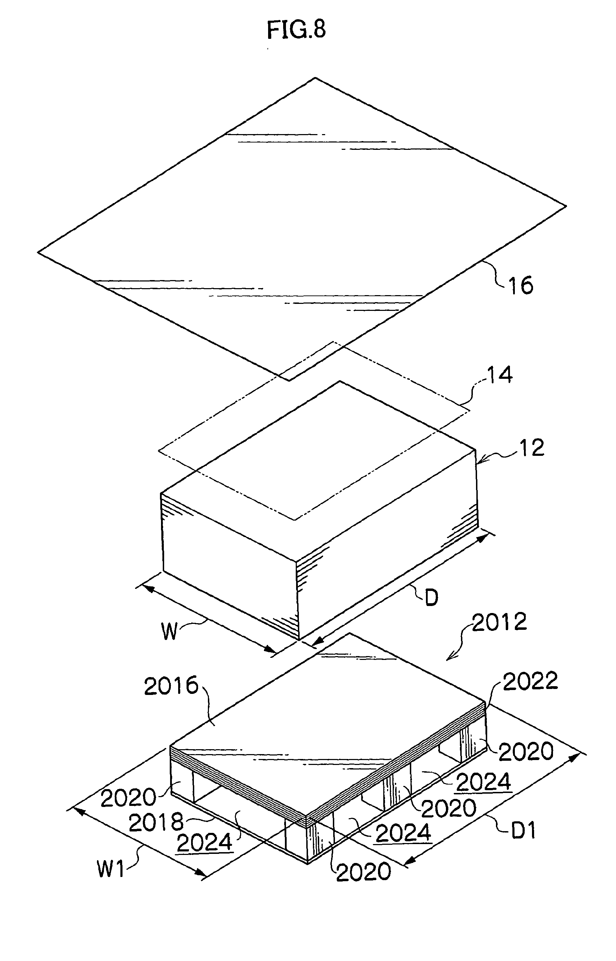

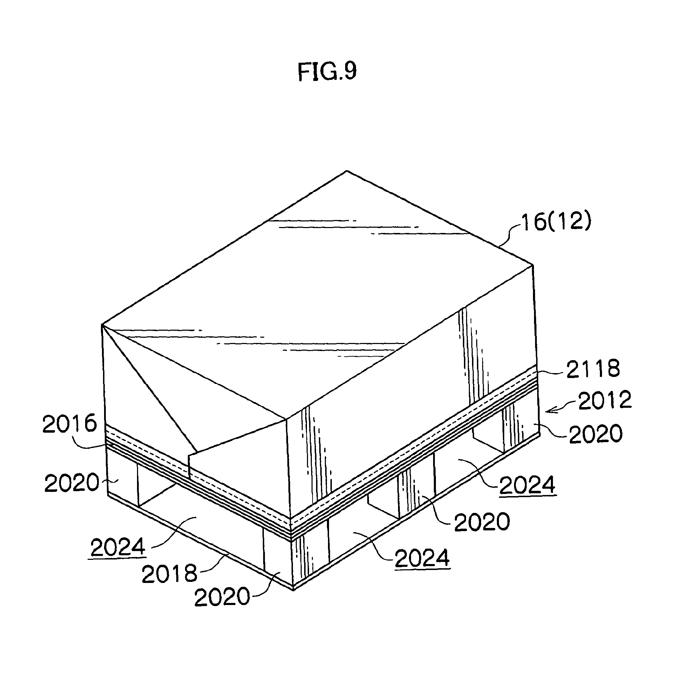

The small pallet 2012 is constructed by a loading plate 2016 on which the layered bundle 12 of the lithographic printing plates 10 is loaded, a bottom plate 2018 placed in parallel with the loading plate 2016, and a plurality (six in this embodiment) of leg portions 2020 placed between the loading plate 2016 and the bottom plate 2018, as shown in Fig. 8 and Fig. 9.

The loading plate 2016 is constructed by layering a plurality of corrugated cardboards 2022 in the same shape in the thickness direction, and adhering them by an adhesive such as an ordinary paste. A width W1 and a depth D1 of the loading plate 2016 are formed to be the same as or a little shorter than a width W and a depth D of the layered bundle 12 of the lithographic printing plates 10.

The leg portion 2020 is in a quadrangular spiral shape by folding the long corrugated cardboard 2022 in a fixed direction at a predetermined position. The entire leg portion 2020 is formed to be a quadrangular cylinder shape opened upward and outward. The leg portions 2020 are placed with a predetermined space from each other, and an inserting hole 2024 is defined between the adjacent leg portions 2020 and between the loading plate 2016 and the bottom plate 2018. The inserting hole 2024 is formed so that a fork of a hand lift or fork lift (both are not shown) for handling the small pallet 2012 (especially, transportation or the like) is capable of being inserted into the insertion hole 2024.

The bottom plate 2018 is constructed by the corrugated cardboard 2022 of the same shape as the corrugated cardboard 2022 constructing the loading plate 2016, and is formed into the shape which does not bulge out of the layered bundle 12 of the lithographic printing plate 10 seen in the plan view, as the loading plate 2016.

The loading plate 2016 and the leg portions 2020, and the leg portions 2020 and the bottom plate 2018 are adhered to each other with an adhesive such as a paste, so that they are not unexpectedly separated or displaced from each other.

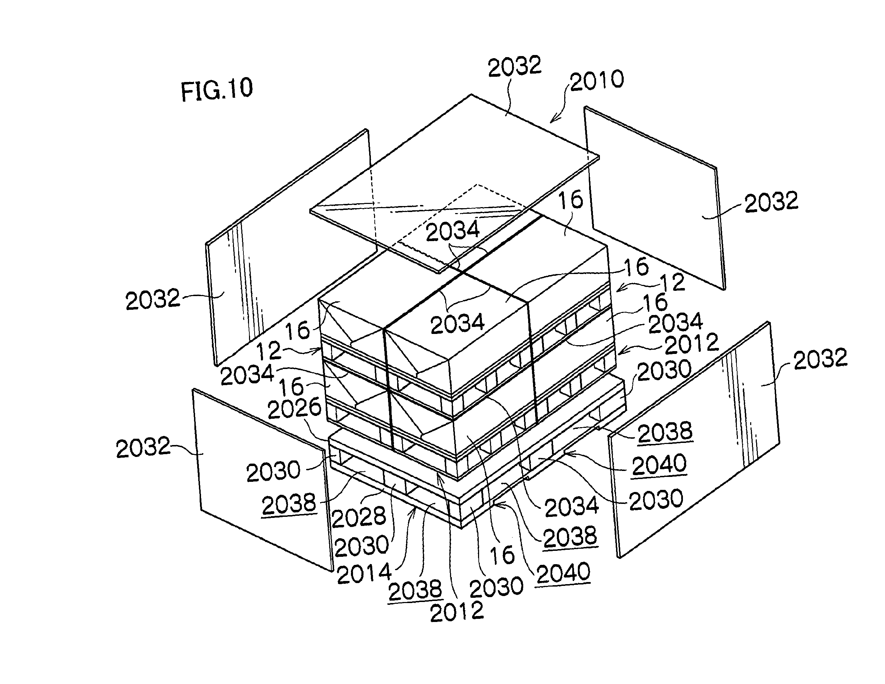

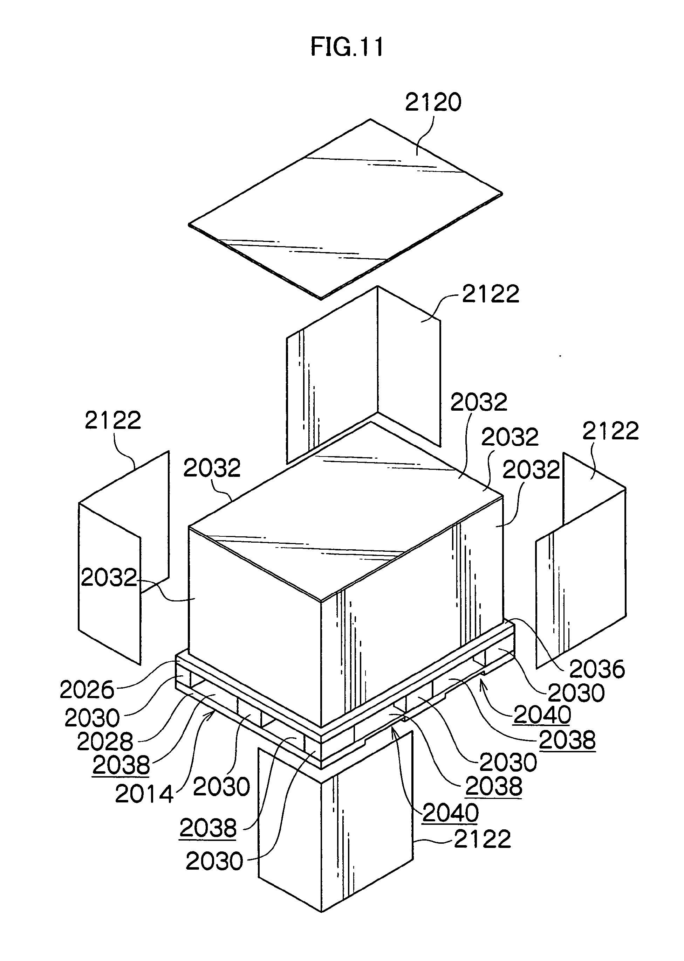

Meanwhile, the large pallet 2014 is constructed by a loading plate 2026 on which the aforementioned small pallet 2012 is further loaded, a bottom plate 2028 which is placed in parallel with this loading plate 2026, and a plurality (nine in this embodiment) of leg portions 2030 placed between the loading plate 2026 and the bottom plate 2028, as shown in Fig. 10 and Fig. 11. These loading plate 2026, bottom plate 2028 and leg portions 2030 are all made of wood.

The loading plate 2026 is formed into a rectangular plate shape so as to bulge outside from a cushioning material 2032 at an outside in the state in which two of the small pallets 2012 are loaded in each of the width direction and the depth direction on the loading plate 2026, and cushioning materials 2032 and 2034 which will be described later are placed outside the small pallets 2012 and between the small pallets 2012, as shown in Fig. 11. The bulged portion becomes a bulged portion 2036 (see Fig. 7). The loading plate 2026 has a fixed strength to be able to bear the total weight in the state in which a total of eight small pallets 2012 are loaded on the loading plate 2026 like this, and the cushioning materials 2032 and 2034 are placed.

The leg portion 2030 is formed into a rectangular parallelepiped shape, and the leg portions 2030 are placed with a predetermined space from each other, and inserting holes 2038 are defined between the adjacent leg portions 2030, and between the loading plate 2026 and the bottom plate 2028. The inserting hole 2038 is formed so that a fork of a fork lift (not shown) for handling the large pallet 2014 (especially, transportation or the like) is capable of being inserted into the inserting hole 2038.

The bottom plate 2028 is formed into a plate shape of approximately the same shape as the loading plate 2026. In the bottom plate 2028 itself, inserting holes 2040 into which a fork of a hand lift for handling the large pallet 2014 is capable of being inserted are formed by making the bottom plate 2028 partially thin-walled from the bottom surface side.

As shown in Fig. 11, the cushioning materials 2032 and 2034 are placed on outer sides of the small pallets 2012, and between the small pallets 2012. When the small pallets 2012 are stacked on each other in the vertical direction, the cushioning materials 2034 are placed. The cushioning materials 2032 and 2034 are formed by a deformable material such as, for example, a corrugated cardboard, and when an impact is applied to the small pallet 2012 from outside, or when the bundles of the lithographic printing plates 10 are close to each other, the cushioning materials 2032 and 2034 are deformed and absorb energy, and can prevent deformation and damage of the lithographic printing plates 10.

In the aforementioned third embodiment, the layered bundle 12 and the protective thick paper 14 are first packaged with the packing paper 16 as shown in Fig. 8. In this case, the layered bundle 12 is packaged so that the image forming surface 10P (see Fig. 1) of the lithographic printing plate 10 is on the underside. The packing paper 16 is constructed by paper having a light blocking effect and dampproof, and when the packing paper 16 is covered from above the layered bundle 12 and the periphery of the packing paper 16 is folded down as shown in Fig. 8, the folded part reaches the side surface of the loading plate 2016 of the small pallet 2012. The lithographic printing plates 10 are packed inside with the packing paper 16 by fixing the contact portion all over the perimeter of the small pallet 2012 with the fixing device such as a craft adhesive tape 2118, and are protected from moisture and blocked from light.

The layered bundle 12 of the lithographic printing plates 10 is packed inside with the packing paper 16, whereby a plurality of lithographic printing plates 10 are practically integrated, and are further integrated with the small pallet 2012. Therefore, handling of the small pallets 2012 is facilitated.

In such a packaged state, the fork (not shown) of a hand lift for handling freight is inserted into the inserting hole 2024 of the small pallet 2012, and the small pallet 2012 is conveyed onto the large pallet 2014.

Subsequently, as shown in Fig. 10, a plurality of (for example, two) small pallets 2012 are respectively arranged at least in one direction of the width direction, depth direction and height direction on the large pallet 2014, and a plurality of (for example, eight) small pallets 2012 as a whole are loaded on the loading plate 2026 of the large pallet 2014. In the process of arranging the small pallets 2012, the cushioning materials 2034 are placed between the adjacent layered bundles 12 of the lithographic printing plates 10, and between the layered bundles 12 of the lithographic printing plates 10 on the lower small pallet 2012 and the upper small pallets 2012. The cushioning materials 2032 are also placed on the outer side and the top surface side of the small pallets 2012. As a result, even when an impact is applied to the layered bundles 12 of the lithographic printing plates 10 from outside, deformation and damage of the lithographic printing plates 10 can be prevented.

As shown in Fig. 10, an outer material 2120 is further placed on an upper side of the cushioning material 2032, and an outer material 2122 is further placed on an outside of the cushioning material 2032. As known also from Fig. 7, a predetermined gap 2124 is constructed between tip ends of the outer materials 2122, at a position of a central portion of each side of the large pallet 2014. In this state, the outer materials 2120 and 2122, and the outer materials 2122 and the large pallet 2014 are temporarily tacked by a craft adhesive tape 2118, and are bound from outside the outer materials 2120 and 2122 with a stretch film 2126. Instead of the stretch film 2126, they may be bounded with a belt or the like generally used for packing and the like.

Further, two ester bands 2128 are placed at each of the long side and short side of the large pallet 2014, and by fastening this ester band 2128, the outer materials 2120, the cushioning materials 2032, the small pallets 2012, the layered bundles 12 and the like are fixed to the large pallet 2014. The small pallets 2012 and the layered bundles 12 are covered with the outer material 2122 from outside, and therefore the layered bundles 12 and the small pallets 2012 are reliably protected from an external force.

In the loading structure 2010 thus constructed, a plurality of small pallets 2012 loaded with the layered bundles 12 of the lithographic printing plates 10 are further loaded on the large pallet 2014, whereby it is possible to handle a large number of lithographic printing plates 10 at a time with the large pallet 2014 as a unit.

In the aforementioned third embodiment, the image forming surface 10P of the lithographic printing plate 10 is also placed on an underside when the packing paper 16 is unsealed as in the first embodiment, and therefore the operation of setting the lithographic printing plate 10 can be facilitated. The third embodiment also has the construction in which packing boxes for packaging the lithographic printing plates 10 are not used, and therefore it does not happen that the used packing boxes become bulky or disposal of the packing boxes takes time and efforts, thus making it possible to reduce cost and labor required for disposal of the packing boxes.

Next, a fourth embodiment of the packaging method according to the present invention will be explained.

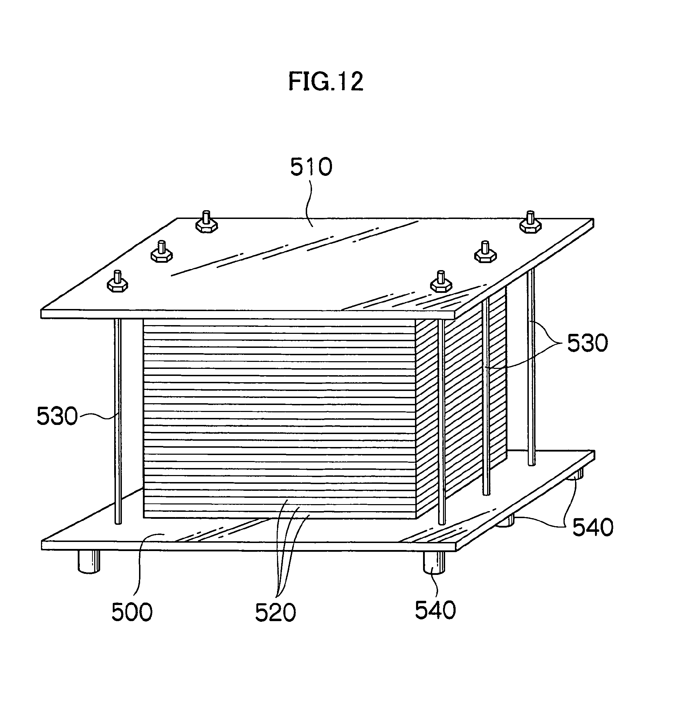

As shown in Fig. 12, in the fourth embodiment, a plurality of packaged bodies 520... are layered between a bottom plate 500 and a top plate 510. Namely, a plurality of packaged bodies 520, 520... are layered on the bottom plate 500, and the top plate 510 is laid on the packaged bodies 520. The bottom plate 500 and the top plate 510 are each formed into a larger rectangular shape than the packaged body 520. The bottom plate 500 and the top plate 510 are connected by a plurality (six in this embodiment) of column members 530, 530... which are provided in the periphery. A plurality (six in this embodiment) of leg portions 540, 540... are provided on an undersurface of the bottom plate 500.

The aforementioned packaged body 520 is constructed by packaging the layered bundle 12, which is made by alternately layering the lithographic printing plates 10 and the inserting paper sheets 14, with the packing paper 16 as shown in Fig. 1 to Fig. 4. On this occasion, the layered bundle 12 is packaged so that the image forming surfaces 10P of the lithographic printing plates 10 are on the side of the undersurface (namely, the opposite surface side from the unsealing surface). As a result, when the packing paper 16 is unpacked, the lithographic printing plate 10 is taken out so that the image forming surface 10P is on the underside, and therefore the operation of setting the lithographic printing plates 10 can be easily performed. In the forth embodiment, a plurality of packaged bodies 520 are layered, and therefore they can be stored in a small space.

In the aforementioned first to fourth embodiments, it is suitable to provide on the surface of the packing paper 16 some indication by which the direction in which the image forming surface 10P of the lithographic printing plate 10 faces can be recognized. For example, it is suitable to paste a label on the surface to which the image forming surface 10P of the lithographic printing plate 10 faces (namely, the opposite surface from the unsealing surface).

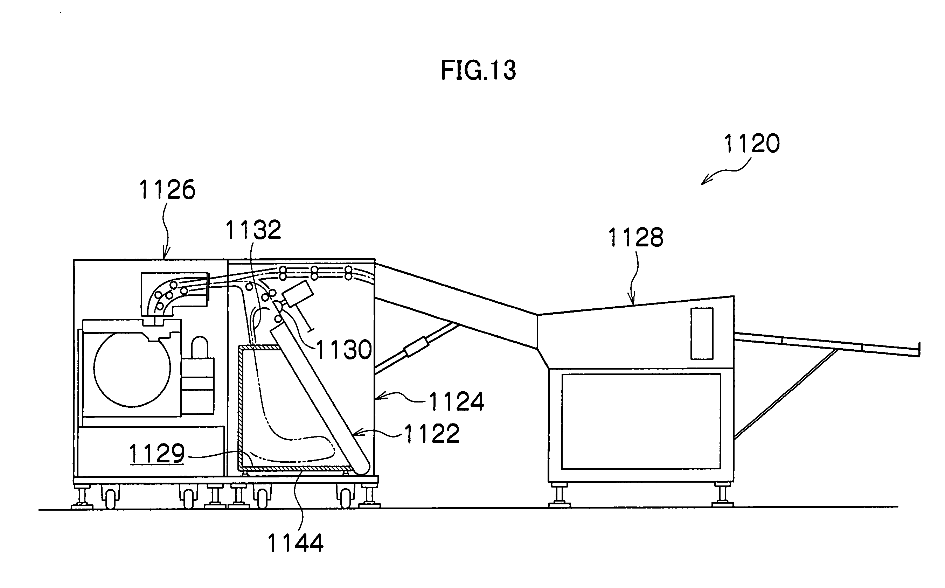

Fig. 13 shows an example of an automatic plate maker for making a plate by using the lithographic printing plate 10.

An automatic plate maker 1120 is constructed by including a lithographic printing plate feeding device 1122, a conveying device 1124, an aligner 1126 and a development fixing device 1128. The lithographic printing plate feeding device 1122 is supported by a support table 1144 in the conveying device 1124. The layered bundle 12 is set in the lithographic printing plate feeding device 1122 so that the image forming surface 10P of the lithographic printing plate 10 faces relatively diagonally downward (the direction opposed to the support table 1144).

A sucker 1130 is mounted to the conveying device 1124 to be contactable to and separable from the loaded layered bundle 12 of the lithographic printing plates 10, and to be movable in the conveying direction (the arrow A direction), and by this sucker 1130, the lithographic printing plates 10 are taken out of the lithographic printing plate feeding device 1122 one by one, and fed to the aligner 1126.

A sensor not shown is mounted to the lithographic printing plate feeding device 1122, so that it can be determined whether the thing sucked by the sucker 1130 is the lithographic printing plate 10 or the inserting paper sheet 14. The sucker 1130 feeds only the lithographic printing plate 10 to the aligner 1126 based on the information from this sensor, and the inserting paper sheet 14 is conveyed to a sheet discharge portion 1129 provided in the lithographic printing plate feeding device 1122.

A friction guide 1132 is mounted at a downstream side in the conveying direction of the lithographic printing plate 10. When the inserting paper sheet 14 is adhered to the lithographic printing plate 10 sucked by the sucker 1130, this friction guide 1132 abuts to the inserting paper sheet 14 on the way of conveyance of the lithographic printing plate 10, and can peel the inserting paper sheet 14 from the lithographic printing plate 10 by friction.

In the lithographic printing plate feeding device 1122 of the automatic plate maker 1120 thus constructed, the layered bundle 12 is set so that the image forming surface 10P of the lithographic printing plate 10 faces relatively diagonally downward. Accordingly, even when, for example, a packing box 1170 for the lithographic printing plate in which the layered bundles 12 are accommodated is placed horizontally, the layered bundle 12 only has to be raised at the time of setting, and does not have to be inverted. Alternatively, if the packing box 1170 for the lithographic printing plate itself is stood diagonally, the accommodated layered bundle 12 is also diagonal, and therefore it can be set in the conveying device 1124 as it is (without changing the inclination angle of the layered bundle 12 to a large extent, or inverting the layered bundle 12), thus further facilitating the operation.

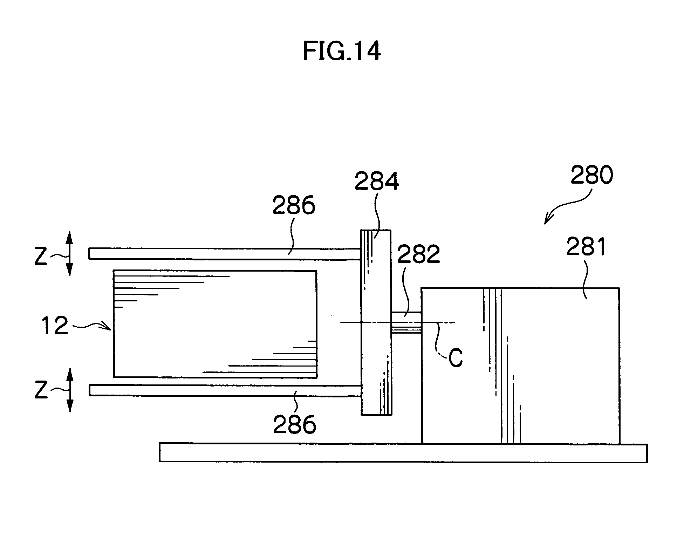

In a lithographic printing plate working line for obtaining the lithographic printing plate 10 of a desired size by working (cutting or the like) an aluminum web coated with a coating film, the layered bundle 12 is constructed in many cases by layering the lithographic printing plates 10 so that the image forming surfaces 10P are on the top side. In this case, the layered bundle 12 can be inverted by using, for example, an inverting device 280 as shown in Fig. 14.

In this inverting device 280, a shaft 282 rotatable around a center line C is protrudedly provided at a body 281, and a pair of gripping plates 286 are provided at a tip end of the shaft 282 via a joint portion 284. The gripping plates 286 are formed into parallel plate shapes, and move in the direction of the arrow Z to be in contact with and separate from each other. Accordingly, the layered bundle 12 constructed by layering the lithographic printing plates 10 so that the image forming surfaces 10P are on the top side is gripped from above and below with the gripping plates 286, and the joint portion 284 and the gripping plates 286 are rotated around the shaft 282, whereby a plurality of lithographic printing plates 10 can be inverted so that the image forming surfaces 10P are on the underside by one integral operation. The layered bundle 12 may be constructed by layering the lithographic printing plates 10 while inverting the lithographic printing plates 10 one by one without using such an inverting device 280, of course.

### [Examples]

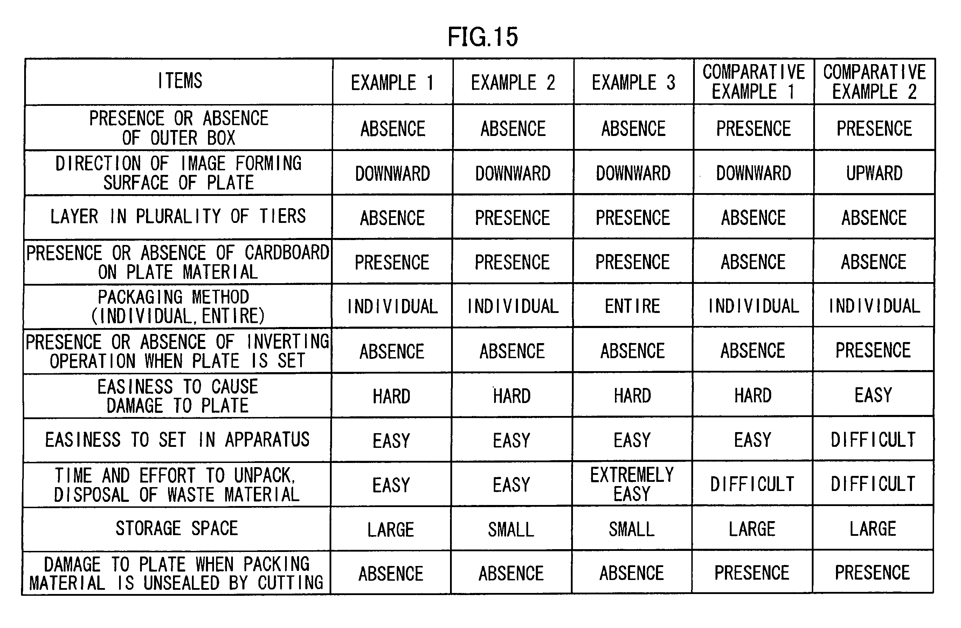

Fig. 15 shows the test result of packaging by the packaging method according to the present invention. In the examples 1 to 3, packaging is performed under the conditions that the protective cardboard are inserted therein without outer boxes (namely, with only the packing paper 16), and the lithographic printing plates 10 are packaged so that the coated surface (corresponding to the image forming surface 10P) faces downward (namely, the coated surface is on the opposite side from the unsealing surface). In the examples 2 and 3, the packaged bodies are laid in a plurality of tiers as shown in the second to the fourth embodiments. Further, while individual packaging is performed in the examples 1 and 2, entire packaging is performed in the example 3.

On the other hand, the comparative examples 1 and 2 are the examples of packaging with the outer boxes without the protective cardboards. In the comparative example 2, packaging is performed so that the coated surface of the lithographic printing plate faces upward (namely, the coated surface is on the side of the unsealing surface).

As understood from the result shown in Fig. 15, much time and efforts are required for unpacking and disposal of the waste materials in the comparative examples 1 and 2 since the outer boxes are used, while unpacking and disposal of the waste materials are easy in the examples 1 to 3 since the outer boxes are not used. Especially in the example 3, the entire packaging is performed, and therefore unpacking and disposal of the waste materials are extremely easy.

Since the coated surface of the lithographic printing plate 10 is placed on the side of the unsealing surface in the comparative example 2, the layered bundle 12 of the lithographic printing plates 10 has to be inverted when the layered bundle 12 is set in the apparatus, which makes the setting operation troublesome, and causes the fear of damaging the lithographic printing plate 10. On the other hand, in the examples 1 to 3, it is not necessary to invert the layered bundle 12, and therefore the setting operation is easy, thus hardly causing the damage to the lithographic printing plate 10.

In the comparative examples 1 and 2, the protective cardboard 22 is not used, and therefore when the packing paper 16 is unsealed with a cutter or the like, the lithographic printing plate 10 easy to damage. On the other hand, in the examples 1 to 3, the protective cardboard 22 is used, and therefore the lithographic printing plate 10 is difficult to damage at the time of unsealing.

While in the comparative examples 1 and 2, the large storage space is required since the layered bundles 12 are not laid in a plurality of tiers, in the examples 2 and 3, the layered bundles 12 are laid in a plurality of tiers and therefore they can be stored even in a small space.

## Claims

1. A packaging method for a lithographic printing plate (10) for packaging by a packing paper (16) the lithographic printing plate (10) with only one side surface formed as an image forming surface, **characterized by** comprising the step of:
packaging the lithographic printing plate (10) with the packing paper (16) so that an unsealing surface of the packing paper (16) is on an opposite side from the image forming surface.

2. The packaging method for the lithographic printing plate (10) according to claim 1, wherein the image forming surface of the lithographic printing plate (10) is constructed by a recording layer which changes in solubility for a developing solution by emission of laser light.
